# EUROPEAN PATENT APPLICATION

(11) **EP 4 503 099 A1**
(43) Date of publication of application: **05.02.2025**
(21) Application number: 22933383.6
(22) Date of filing: 24.03.2022
(51) Int. Cl.: H01L 21/31, H01L 21/318

(54) **METHOD FOR MANUFACTURING SEMICONDUCTOR DEVICE, SUBSTRATE PROCESSING METHOD, SUBSTRATE PROCESSING DEVICE, AND PROGRAM**

(71) Applicant: Kokusai Electric Corporation, Tokyo 101-0045 (JP)
(72) Inventor: HATTA, Hiroki, Toyama-shi, Toyama 939-2393 (JP); TAKEBAYASHI, Yuji, Toyama-shi, Toyama 939-2393 (JP); TANAKA, Shota, Toyama-shi, Toyama 939-2393 (JP); NAGAHASHI, Tomoya, Toyama-shi, Toyama 939-2393 (JP); OKAJIMA, Yusaku, Toyama-shi, Toyama 939-2393 (JP)
(74) Representative: Verscht, Thomas Kurt Albert
(86) International application number: PCT/JP2022/013892
(87) International publication number: WO 2023/181242

(57) **Abstract**

The present invention can improve the step coverage performance of a film formed on a substrate having a recess. This method for manufacturing a semiconductor device comprises: (a) a step for supplying, into a recess in a substrate provided with an adsorption site on a surface thereof, a feedstock gas at a speed faster than the adsorption speed at which a precursor of the feedstock gas is adsorbed onto the adsorption site; (b) a step for supplying a purge gas into the recess; and (c) a step for supplying the feedstock gas into the recess at a speed slower than the aforementioned adsorption speed.

## Description

### [Technical Field]

The present disclosure relates to a method of manufacturing a semiconductor device, a substrate processing method, a substrate processing apparatus and a program.

### [Related Art]

In Patent Document 1, as a part of a manufacturing process of a semiconductor device, by supplying an inert gas or a hydrogen-containing gas toward a substrate together with a source gas, a technique capable of setting a flow velocity of the source gas flowing in a direction parallel to a surface of the substrate to be greater than a flow velocity of the inert gas flowing in the direction parallel to the surface of the substrate in a step of purging an inside of a process vessel is disclosed.

### [Related Art Document]

### [Patent Document]

Patent Document 1: Japanese Patent Laid-Open No. 2011-129879.

### [Disclosure]

### [Technical Problem]

In recent years, an aspect ratio of a concave structure such as a groove formed on the substrate may increase in accordance with a reduction of a cell area due to a miniaturization of a device such as the semiconductor device, and it is necessary to improve a step coverage performance, for example, when a film is formed on the substrate provided with a deeper concave structure. In order to improve the step coverage performance, it is preferable to sufficiently supply a gas to a lower portion of the concave structure. However, when trying to sufficiently supply the gas to the lower portion of the concave structure for coping with an increase in the aspect ratio, an upper portion of the device may be supplied with an excessive amount of a process gas, and the step coverage performance may not be improved. Further, in order to improve the step coverage performance, while sufficiently supplying the gas to the lower portion of the concave structure, it is necessary to suppress a supply amount of the process gas to the upper portion of the device.

It is an object of the present disclosure to provide a technique capable of improving the step coverage performance of the film formed on the substrate provided with the concave structure.

### [Technical Solution]

According to an embodiment of the present disclosure, there is provided a technique that includes: (a) supplying a source gas to a concave structure of a substrate provided with an adsorption site on a surface thereof at a rate faster than an adsorption rate at which a precursor of the source gas is adsorbed to the adsorption site; (b) supplying a purge gas to the concave structure; and (c) supplying the source gas to the concave structure at a rate slower than the adsorption rate.

### [Advantageous Effects]

According to some embodiments of the present disclosure, it is possible to improve a step coverage of a film formed on a substrate provided with a concave structure.

### [Brief Description of Drawings]

FIG. 1 is a diagram schematically illustrating a vertical cross-section of a substrate processing apparatus according to one or more embodiments of the present disclosure.
FIG. 2 is a diagram specifically illustrating a vertical cross-section of a substrate support shown in FIG. 1.
FIG. 3(A) is a diagram schematically illustrating a first gas supplier according to the embodiments of the present disclosure, FIG. 3(B) is a diagram schematically illustrating a second gas supplier according to the embodiments of the present disclosure and FIG. 3(C) is a diagram schematically illustrating a third gas supplier according to the embodiments of the present disclosure.
FIGS. 4(A) through 4(C) are diagrams schematically illustrating examples of a chemical structural formula of a first gas according to the embodiments of the present disclosure.
FIG. 5(A) is a diagram schematically illustrating a process chamber exhauster according to the embodiments of the present disclosure and FIG. 5(B) is a diagram schematically illustrating a transfer chamber exhauster according to the embodiments of the present disclosure.
FIG. 6 is a block diagram schematically illustrating a configuration of a controller and related components of the substrate processing apparatus according to the embodiments of the present disclosure.
FIG. 7 is a diagram schematically illustrating a substrate processing sequence according to the embodiments of the present disclosure.
FIG. 8(A) is a diagram schematically illustrating a supply sequence of the first gas according to the embodiments of the present disclosure and FIG. 8(B) is a diagram schematically illustrating a supply sequence of a second gas according to the embodiments of the present disclosure.
FIG. 9 is a diagram schematically illustrating a state of a surface of a substrate when the first gas is supplied according to the embodiments of the present disclosure.
FIG. 10(A) is a diagram schematically illustrating a state of the surface of the substrate when a first gas flash supply is performed, FIG. 10(B) is a diagram schematically illustrating a state of the surface of the substrate when a purge gas is supplied, FIG. 10(C) is a diagram schematically illustrating a state of the surface of the substrate when a first gas continuous supply is performed and FIG. 10(D) is a diagram schematically illustrating a state of the surface of the substrate when the second gas is supplied.

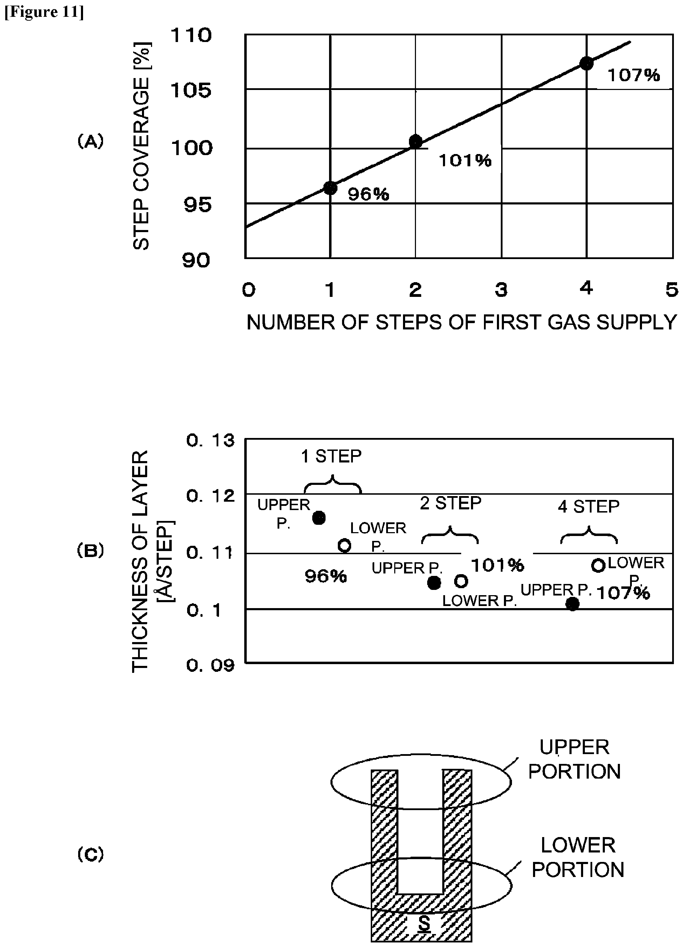

FIG. 11(A) is a diagram schematically illustrating a relationship between the number of steps of a first gas supply and a step coverage according to an example of the embodiments of the present disclosure, FIG. 11(B) is a diagram schematically illustrating a relationship between the number of steps of the first gas supply and a thickness of a layer formed on an upper portion or a lower portion of a concave structure of the substrate according to the example of the embodiments of the present disclosure and FIG. 11(C) is a diagram schematically illustrating the upper portion and the lower portion of the concave structure of the substrate according to the example of the embodiments of the present disclosure.

### [Detailed Description]

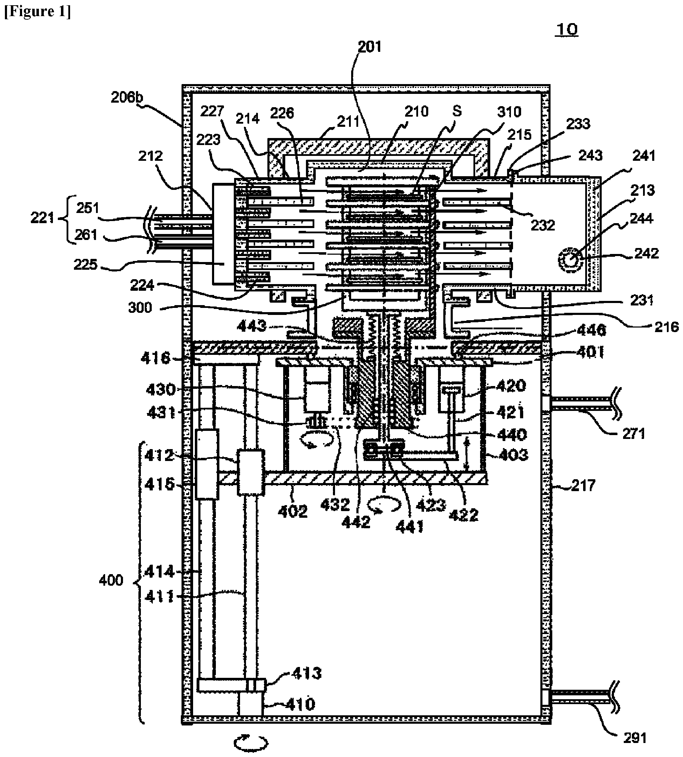

Hereinafter, one or more embodiments (also simply referred to as "embodiments") according to the technique of the present disclosure will be described with reference to FIGS. 1 to 9, FIGS. 10(A) to 10(D) and FIGS. 11(A) to 11(C). The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match.

### (1) Configuration of Substrate Processing Apparatus

A configuration of a substrate processing apparatus 10 according to the present embodiments will be described mainly with reference to FIG. 1.

The substrate processing apparatus 10 includes a reaction tube storage chamber 206b. In the reaction tube storage chamber 206b, a reaction tube 210 of a cylindrical shape extending in a vertical direction, a heater 211 serving as a heating structure (furnace body) installed on an outer periphery of the reaction tube 210, a gas supply structure 212 serving as a part of a gas supplier, and a gas exhaust structure 213 serving as a part of a gas exhauster are provided. The gas supplier may further include an upstream side gas guide 214 or nozzles 223 and 224, which will be described later. Further, the gas exhauster may further include a downstream side gas guide 215, which will be described later. In the reaction tube 210, a portion in which a substrate S is processed may also be referred to as a "process chamber 201".

The gas supply structure 212 is provided upstream in a gas flow direction in the reaction tube 210, and a gas is supplied into the reaction tube 210 through the gas supply structure 212. Then, the gas is supplied to the substrate S in a horizontal direction. The gas exhaust structure 213 is provided downstream in the gas flow direction in the reaction tube 210, and the gas in the reaction tube 210 is discharged (exhausted) through the gas exhaust structure 213. The gas supply structure 212, an inner portion of the reaction tube 210 and the gas exhaust structure 213 communicate with one another in the horizontal direction.

On an upstream side of the reaction tube 210 between the reaction tube 210 and the gas supply structure 212, the upstream side gas guide 214 configured to adjust a flow of the gas supplied through the gas supply structure 212 is provided. Further, on a downstream side of the reaction tube 210 between the reaction tube 210 and the gas exhaust structure 213, the downstream side gas guide 215 configured to adjust the flow of the gas discharged from the reaction tube 210 is provided. A lower end of the reaction tube 210 is supported by a manifold 216.

The reaction tube 210, the upstream side gas guide 214 and the downstream side gas guide 215 are implemented as a continuous structure. For example, each of the reaction tube 210, the upstream side gas guide 214 and the downstream side gas guide 215 is made of a material such as quartz and silicon carbide (SiC). Further, each of the reaction tube 210, the upstream side gas guide 214 and the downstream side gas guide 215 is constituted by a heat transmittable structure capable of transmitting a heat radiated from the heater 211. The heat of the heater 211 can heat the substrate S and the gas.

The gas supply structure 212 is connected to each of a gas supply pipe 251 and a gas supply pipe 261, and includes a distribution structure 225 configured to distribute the gas supplied through each gas supply pipe described above. Nozzle 223 and nozzles 224 are provided at a downstream side of the distribution structure 225. As described later, it is possible to supply different types of gases through the gas supply pipe 251 and the gas supply pipe 261, respectively. The nozzle 223 and the nozzle 224 are arranged up and down in the vertical direction or side by side in the horizontal direction. In the present embodiments, the gas supply pipe 251 and the gas supply pipe 261 may also be collectively or individually referred to as a "gas supply pipe 221". Each of the nozzles may also be referred to as a "gas ejection structure".

The distribution structure 225 is configured such that each gas can be supplied to the nozzles 223 through the gas supply pipe 251 and to the nozzles 224 through the gas supply pipe 261. For example, a gas flow path can be provided for each combination of the gas supply pipe and the nozzle corresponding to the gas supply pipe. Thereby, since the gases respectively supplied through the gas supply pipes described above are not mixed, it is possible to suppress a generation of particles that may be generated when the gases are mixed in the distribution structure 225.

The upstream side gas guide 214 includes a housing 227 and a partition plate 226. The partition plate 226 extends in the horizontal direction. The "horizontal direction" may refer to a direction toward a side wall of the housing 227. A plurality of partition plates 226 are arranged in the vertical direction. The partition plate 226 is fixed to the side wall of the housing 227 such that it is possible to prevent the gas from flowing beyond the partition plate 226 into an adjacent region below or above the partition plate 226. By preventing the gas from flowing beyond the partition plate 226, it is possible to reliably form a gas flow described later.

The partition plate 226 is a continuous structure extending in the horizontal direction and provided without a hole. The partition plates 226 are provided at positions corresponding to a plurality of substrates S, respectively. The nozzle 223 and the nozzle 224 are arranged between adjacent partition plates 226 or between the partition plate 226 and the housing 227.

The flow of the gas ejected through the nozzle 223 or the nozzle 224 is adjusted by the partition plate 226, and then the gas whose flow is adjusted is supplied to a surface of the substrate S. That is, when viewed from the substrate S, the gas is supplied along a lateral direction of the substrate S. Since the partition plate 226 is a continuous structure extending in the horizontal direction and provided without a hole, a mainstream of the gas is restrained from flowing in the vertical direction and flows in the horizontal direction. Therefore, a pressure loss of the gas reaching each substrate S can be uniformized along the vertical direction.

The downstream side gas guide 215 is configured such that a ceiling thereof is provided above an uppermost substrate among the substrates S supported by a substrate support structure 300 described later, and a bottom thereof is provided below a lowermost substrate among the substrates S supported by the substrate support structure 300.

The downstream side gas guide 215 includes a housing 231 and a partition plate 232. The partition plate 232 extends in the horizontal direction. The "horizontal direction" may refer to a direction toward a side wall of the housing 231. Further, a plurality of partition plates 232 are arranged in the vertical direction. The partition plate 232 is fixed to the side wall of the housing 231 such that it is possible to prevent the gas from flowing beyond the partition plate 232 into an adjacent region below or above the partition plate 232. By preventing the gas from flowing beyond the partition plate 232, it is possible to reliably form the gas flow described later. A flange 233 is provided on a portion of the housing 231 that comes into contact with the gas exhaust structure 213.

The partition plate 232 is a continuous structure extending in the horizontal direction and provided without a hole. The partition plates 232 are provided at positions corresponding to the substrates S and corresponding to the partition plates 226, respectively. It is preferable that the partition plate 226 and the partition plate 232 corresponding to the partition plate 226 are provided at the same height. Further, when processing the substrate S, it is preferable that the substrate S, the partition plate 226 corresponding to the substrate S and the partition plate 232 corresponding to the partition plate 226 are provided at the same height. With such a structure, the gas flow in the horizontal direction passing over the partition plate 226, the substrate S and the partition plate 232 is formed by the gas supplied through each nozzle, as shown by each arrow in FIG. 1. By configuring the partition plate 232 as described above, it is possible to uniformize the pressure loss of the gas ejected (or discharged) through each of the substrates S. Therefore, the flow of the gas passing through each of the substrates S is formed in the horizontal direction toward the gas exhaust structure 213 while suppressing a gas flow in the vertical direction.

By providing the partition plates 226 and the partition plates 232, it is possible to uniformize the pressure loss in the vertical direction at both an upstream and a downstream of each of the substrates S. As a result, it is possible to reliably form a horizontal gas flow over the partition plate 226, the substrate S and the partition plate 232 while suppressing a vertical gas flow.

The gas exhaust structure 213 is provided downstream of the downstream side gas guide 215. The gas exhaust structure 213 is constituted mainly by a housing 241 and a gas exhaust pipe connection structure 242. A flange 243 is provided on a portion of the housing 241 adjacent to the downstream side gas guide 215. Since the gas exhaust structure 213 is made of a metal and the downstream side gas guide 215 is made of quartz, the flange 233 and the flange 243 are fixed to each other with a fixing structure such as a screw via a cushioning material such as an O-ring. It is preferable that the flange 243 is arranged outside the heater 211 such that an influence of the heater 211 on the O-ring can be suppressed.

The gas exhaust structure 213 communicates with a space in the downstream side gas guide 215. The upper ends of the housing 231 and the housing 241 form a structure with a continuous height. That is, a height of a ceiling of the housing 231 is the same as that of a ceiling of the housing 241, and a height of a bottom of the housing 231 is configured to be the same as that of a bottom of the housing 241. An exhaust hole 244 is provided at a downstream side of the housing 241 on a lower portion of the housing 241 or in the horizontal direction. The gas exhaust structure 213 is provided in a lateral direction of the reaction tube 210, and is a lateral exhaust structure configured to exhaust the gas along the lateral direction of the substrate S.

The gas that has passed through the downstream side gas guide 215 is exhausted through the exhaust hole 244. When the gas is exhausted through the exhaust hole 244, since the gas exhaust structure 213 is not provided with a structure similar to the partition plate described above, the gas flow whose vertical component is non-zero is formed toward the exhaust hole 244.

A transfer chamber 217 is installed below the reaction tube 210 via the manifold 216. In the transfer chamber 217, the substrate S may be transferred to (or placed on) the substrate support structure (hereinafter, may also be simply referred to as a "boat") 300 by a vacuum transfer robot via a substrate loading/unloading port, or the substrate S may be transferred (or taken) out of the substrate support structure 300 by the vacuum transfer robot.

Inside the transfer chamber 217, the substrate support structure 300, a partition plate support 310, and a vertical driving structure (vertical driver) 400 constituting a first driving structure (first driver) configured to drive the substrate support structure 300 and the partition plate support 310 (hereinafter, also collectively referred to as a "substrate retainer") in the vertical direction and a rotational direction can be stored. FIG. 1 shows a state in which the substrate support structure 300 is elevated by the vertical driving structure 400 and stored in the reaction tube 210.

The vertical driving structure 400 constituting the first driving structure may include: as drive sources, a vertical driving motor 410; a rotational driving motor 430; and a boat vertical driving structure 420 provided with a linear actuator serving as a substrate support elevator capable of driving the substrate support structure 300 in the vertical direction.

By rotationally driving a ball screw 411, the vertical driving motor 410 serving as a partition plate support elevator moves a nut 412 screwed with respect to the ball screw 411 in the vertical direction along the ball screw 411. As a result, the partition plate support 310 and the substrate support structure 300 are driven in the vertical direction between the reaction tube 210 and the transfer chamber 217 together with a base plate 402 fixing the nut 412. The base plate 402 is also fixed to a ball guide 415 that is engaged with a guide shaft 414, and is configured to be capable of being smoothly moved in the vertical direction along the guide shaft 414. An upper end portion and a lower end portion of each of the guide shaft 414 and the ball screw 411 are fixed to a fixing plate 416 and a fixing plate 413, respectively.

The rotational driving motor 430 and the boat vertical driving structure 420 provided with the linear actuator constitute a second driving structure, and are fixed to a base flange 401 serving as a lid supported by a side plate 403 on the base plate 402.

The rotational driving motor 430 is configured to drive a rotation transmission belt 432 that engages with a tooth structure 431 attached to a front end (tip) thereof, and is configured to rotationally drive a support structure 440 that engages with the rotation transmission belt 432. The support structure 440 is configured to support the partition plate support 310 by a base structure 311, and is configured to rotate the partition plate support 310 and the substrate support structure 300 by being driven by the rotational driving motor 430 via the rotation transmission belt 432.

The boat vertical driving structure 420 provided with the linear actuator is configured to drive a shaft 421 in the vertical direction. A plate 422 is attached to a front end (tip) of the shaft 421. The plate 422 is connected to a support 441 fixed to a base structure 301 of the substrate support structure 300 via a bearing 423. By connecting the support 441 to the plate 422 via the bearing 423, when the partition plate support 310 is rotationally driven by the rotational driving motor 430, it is possible to rotate the substrate support structure 300 together with the partition plate support 310.

On the other hand, the support 441 is supported by the support structure 440 via a linear guide bearing 442. With such a configuration, when the shaft 421 is driven in the vertical direction by the boat vertical driving structure 420 provided with the linear actuator, it is possible to drive the support 441 fixed to the substrate support structure 300 in the vertical direction relative to the support structure 440 fixed to the partition plate support 310.

The support structure 440 fixed to the partition plate support 310 and the support 441 fixed to the substrate support structure 300 are connected by a vacuum bellows 443.

An O-ring 446 for a vacuum seal is installed on an upper surface of the base flange 401 serving as the lid, and as shown in FIG. 1, by driving the vertical driving motor 410 such that the upper surface of the base flange 401 is elevated to a position where it is pressed against the transfer chamber 217, it is possible to maintain an inside of the reaction tube 210 airtight.

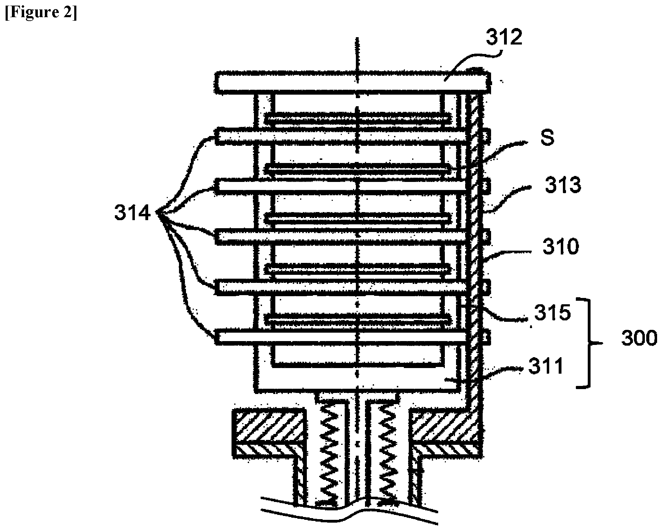

Subsequently, a substrate support will be described in detail with reference to FIGS. 1 and 2. The substrate support is constituted at least by the substrate support structure 300 configured to support the substrate S, and is accommodated in the reaction tube 210. The substrates S are arranged directly below an inner wall of a top plate of the reaction tube 210. Further, the substrate support is configured such that a process of replacing the substrate S by the vacuum transfer robot in the transfer chamber 217 via a substrate loading/unloading port (not shown) can be performed and a process of loading the substrate S (which is replaced) into the reaction tube 210 such that a film forming step of forming a film on the surface of the substrate S can be performed. For example, the substrate loading/unloading port is provided on a side wall of the transfer chamber 217. Further, the substrate support may further include the partition plate support 310.

A plurality of partition plates 314 of a disk shape are fixed to the partition plate support 310 at a predetermined pitch therebetween at a support column 313 supported between the base structure 311 and a top plate 312. The substrate support structure 300 includes a configuration in which a plurality of support rods 315 are supported on the base structure 311 and the substrates S are supported by the plurality of support rods 315 at a predetermined interval therebetween.

The substrates S are placed on the substrate support structure 300 at the predetermined interval therebetween by the plurality of support rods 315 supported by the base structure 311. Spaces between adjacent substrates S supported by the plurality of support rods 315 are partitioned by the partition plates 314 (which are of a disk shape) fixed (or supported) at the predetermined interval (pitch) to the support column 313 supported by the partition plate support 310. According to the present embodiments, the partition plate 314 is arranged directly below the substrate S. The partition plates 314 may be provided above or below their adjacent substrates S. Alternatively, the partition plates 314 may be provided above and below their adjacent substrates S. The partition plates 314 are configured to separate the spaces between adjacent substrates S from one another.

The predetermined interval between the substrates S placed on the substrate support structure 300 is the same as a vertical interval of the partition plates 314 fixed to the partition plate support 310. Further, a diameter of the partition plate 314 is set to be larger than a diameter of the substrate S.

The substrate support structure 300 is configured to support a plurality of substrates (for example, 5 substrates) as the substrates S in a multistage manner in the vertical direction by the plurality of support rods 315. Each of the base structure 311, the partition plate 314 and the plurality of support rods 315 is made of a material such as quartz and silicon carbide (SiC). Further, the present embodiments will be described by way of an example in which 5 substrates are supported by the substrate support structure 300 as the substrates S. However, the present embodiments are not limited thereto. For example, the substrate support structure 300 may be configured to support about 5 substrates to 50 substrates as the substrates S. Further, the partition plate 314 of the partition plate support 310 may also be referred to as a "separator".

The partition plate support 310 and the substrate support structure 300 are driven by the vertical driving structure 400 in the vertical direction between the reaction tube 210 and the transfer chamber 217 and in the rotational direction around a center of the substrate S supported by the substrate support structure 300.

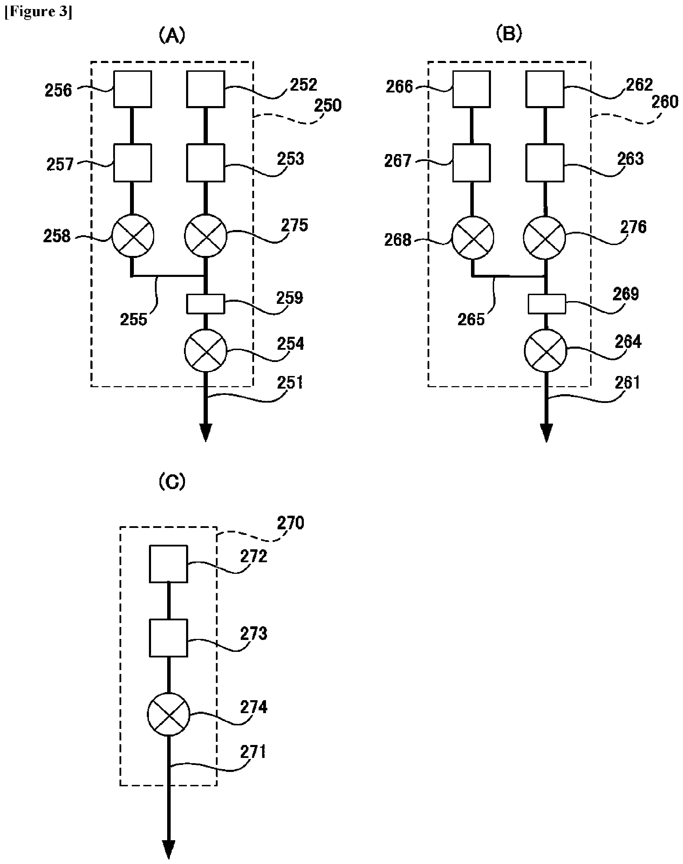

Subsequently, the gas supplier will be described in detail with reference to FIGS. 3(A) through 3(C). As shown in FIG. 3(A), a first gas supply source 252, a mass flow controller (MFC) 253 serving as a flow rate controller (a flow rate control structure), a valve 275 serving as an opening/closing valve, a tank 259 serving as a storage configured to store a gas and a valve 254 serving as an opening/closing valve are sequentially installed at the gas supply pipe 251 in this order from an upstream side to a downstream side of the gas supply pipe 251.

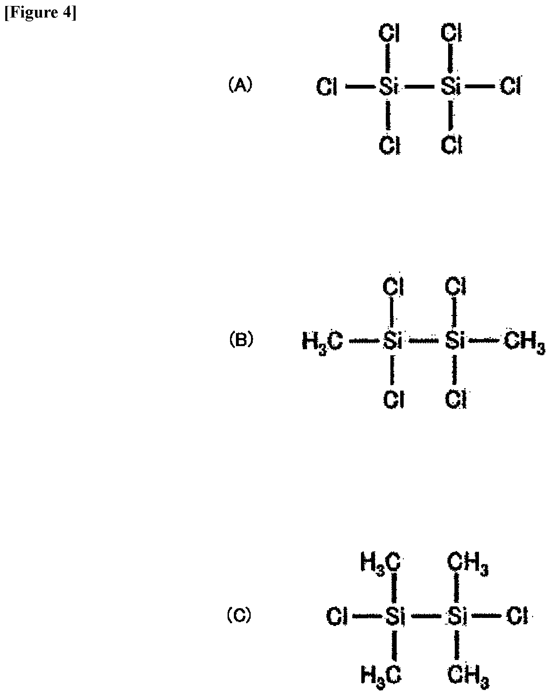

The first gas supply source 252 is a source of a first gas containing a first element (also referred to as a "first element-containing gas"). The first gas serves as a source gas, that is, one of process gases. According to the present embodiments, at least two silicon (Si) atoms are bonded in a single molecule of the first gas. For example, the first gas may refer to a gas containing silicon and chlorine (Cl). For example, the first gas may refer to a source gas containing a silicon - silicon (Si - Si) bond such as disilicon hexachloride (Si₂Cl₆, hexachlorodisilane, abbreviated as HCDS) gas shown in FIG. 4(A). As shown in FIG. 4(A), the HCDS gas contains silicon and a chloro group (chloride) in its chemical structural formula (in one molecule).

The Si - Si bond contains enough energy to be decomposed by a collision with a wall constituting a concave structure (or a recess) of the substrate S, which will be described later, in the reaction tube 210. According to the present embodiments, the term "decomposed" means that the Si - Si bond is broken. That is, the Si - Si bond is broken by the collision with the wall.

A first gas supplier (which is a first gas supply structure or a first gas supply system) 250 is constituted mainly by the gas supply pipe 251, the MFC 253, the valve 275, the tank 259 and the valve 254. The first gas supplier 250 may also be referred to as a "silicon-containing gas supplier" which is a silicon-containing gas supply structure or a silicon-containing gas supply system.

A gas supply pipe 255 is connected to the gas supply pipe 251 between the valve 275 and the tank 259. An inert gas supply source 256, an MFC 257 and a valve 258 serving as an opening/closing valve are sequentially installed at the gas supply pipe 255 in this order from an upstream side to a downstream side of the gas supply pipe 255. An inert gas (for example, nitrogen (N₂) gas) is supplied from the inert gas supply source 256.

A first inert gas supplier (which is a first inert gas supply structure or a first inert gas supply system) is constituted mainly by the gas supply pipe 255, the MFC 257 and the valve 258. The inert gas supplied from the inert gas supply source 256 acts as a purge gas for purging the gas remaining in the reaction tube 210 when performing a substrate processing described later. The first gas supplier 250 may further include the first inert gas supplier.

While the present embodiments will be described by way of an example in which the HCDS gas is used as the first gas, the first gas is not limited thereto. For example, a gas containing silicon and a Si - Si bond may be used as the first gas. That is, for example, a gas such as 1, 1, 2, 2 - tetrachloro - 1, 2 - dimethyldisilane ((CH₃)₂Si₂Cl₄, abbreviated as TCDMDS) and 1, 2 - dichloro - 1, 1, 2, 2 - tetramethyldisilane ((CH₃)₄Si₂Cl₂, abbreviated as DCTMDS) may be used as the first gas. As shown in FIG. 4(B), the TCDMDS contains a Si - Si bond, and further contains a chloro group and an alkylene group. Further, as shown in FIG. 4(C), the DCTMDS contains a Si - Si bond, and further contains a chloro group and an alkylene group.

As shown in FIG. 3(B), a second gas supply source 262, a mass flow controller (MFC) 263 serving as a flow rate controller (a flow rate control structure), a valve 276 serving as an opening/closing valve, a tank 269 serving as a storage configured to store a gas and a valve 264 serving as an opening/closing valve are sequentially installed at the gas supply pipe 261 in this order from an upstream side to a downstream side of the gas supply pipe 261.

The second gas supply source 262 is a source of a second gas containing a second element (also referred to as a "second element-containing gas"). The second gas is a gas different from the first gas, and serves as one of the process gases. Further, the second gas may serve as a modification gas or a reactive gas reacting with a precursor of the first gas serving as the source gas.

According to the present embodiments, the second gas contains the second element different from the first element of the first gas. For example, the second element may be one of oxygen (O), nitrogen (N) and carbon (C). According to the present embodiments, for example, the second gas is a gas containing hydrogen (H) and nitrogen, and is a hydrogen nitride-based gas containing a nitrogen - hydrogen (N - H) bond such as ammonia (NH₃) gas, diazene (N₂H₂) gas, hydrazine (N₂H₄) gas and N₃H₈ gas.

A second gas supplier (which is a second gas supply structure or a second gas supply system) 260 is constituted mainly by the gas supply pipe 261, the MFC 263, the valve 276, the tank 269 and the valve 264.

A gas supply pipe 265 is connected to the gas supply pipe 261 between the valve 276 and the tank 269. An inert gas supply source 266, an MFC 267 and a valve 268 serving as an opening/closing valve are sequentially installed at the gas supply pipe 265 in this order from an upstream side to a downstream side of the gas supply pipe 265. The inert gas (for example, nitrogen (N₂) gas) is supplied from the inert gas supply source 266.

A second inert gas supplier (which is a second inert gas supply structure or a second inert gas supply system) is constituted mainly by the gas supply pipe 265, the MFC 267 and the valve 268. The inert gas supplied from the inert gas supply source 266 acts as the purge gas for purging the gas remaining in the reaction tube 210 when performing the substrate processing described later. The second gas supplier 260 may further include the second inert gas supplier.

As shown in FIG. 3(C), a third gas supply source 272, a mass flow controller (MFC) 273 serving as a flow rate controller (a flow rate control structure) and a valve 274 serving as an opening/closing valve are sequentially installed at a gas supply pipe 271 in this order from an upstream side to a downstream side of the gas supply pipe 271. The gas supply pipe 271 is connected to the transfer chamber 217. The inert gas is supplied when the transfer chamber 217 is set to an inert gas atmosphere or when the transfer chamber 217 is exhausted to a vacuum state.

The third gas supply source 272 is a source of the inert gas. A third gas supplier (which is a third gas supply structure or a third gas supply system) 270 is constituted mainly by the gas supply pipe 271, the MFC 273 and the valve 274. The third gas supplier 270 may also be referred to as a "transfer chamber gas supplier" which is a transfer chamber gas supply structure or a transfer chamber gas supply system.

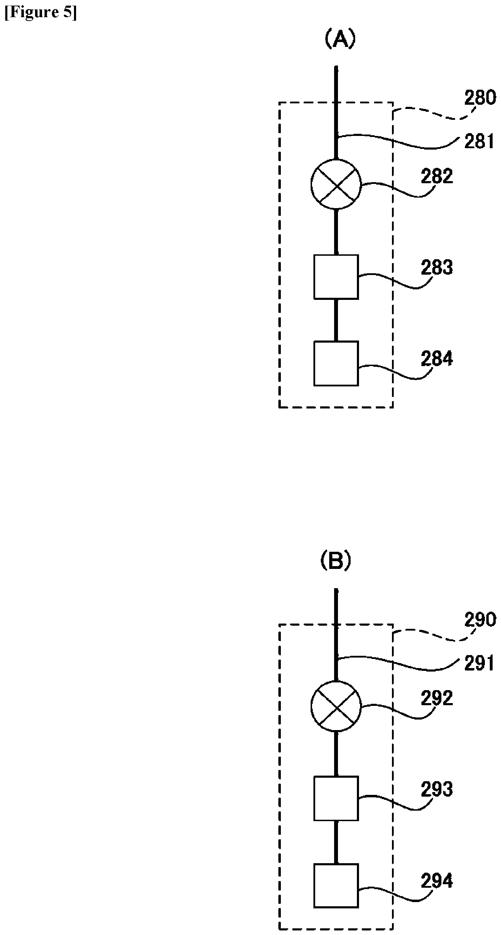

Subsequently, an exhauster (which is an exhaust structure or an exhaust system) will be described with reference to FIGS. 5(A) and 5(B). An exhauster 280 configured to exhaust an inner atmosphere of the reaction tube 210 includes an exhaust pipe 281 that communicates with the reaction tube 210, and is connected to the housing 241 via the gas exhaust pipe connection structure 242.

As shown in FIG. 5(A), a vacuum pump 284 serving as a vacuum exhaust apparatus is connected to the exhaust pipe 281 via a valve 282 serving as an opening/closing valve and an APC (Automatic Pressure Controller) valve 283 serving as a pressure regulator (which is a pressure adjusting structure). Thereby, the reaction tube 210 is vacuum-exhausted such that an inner pressure of the reaction tube 210 reaches and is maintained at a predetermined pressure (vacuum degree). The exhaust pipe 281, the valve 282 and the APC valve 283 may also be collectively referred to as the exhauster 280. The exhauster 280 may also be referred to as a "process chamber exhauster". The exhauster 280 may further include the vacuum pump 284.

An exhauster 290 configured to exhaust an inner atmosphere of the transfer chamber 217 includes an exhaust pipe 291 that is connected to the transfer chamber 217 and that communicates with an inside of the transfer chamber 217.

As shown in FIG. 5(B), a vacuum pump 294 serving as a vacuum exhaust apparatus is connected to the exhaust pipe 291 via a valve 292 serving as an opening/closing valve and an APC (Automatic Pressure Controller) valve 293. Thereby, the transfer chamber 217 is vacuum-exhausted such that an inner pressure of the transfer chamber 217 reaches and is maintained at a predetermined pressure (vacuum degree). The exhaust pipe 291, the valve 292 and the APC valve 293 may also be collectively referred to as the exhauster 290. The exhauster 290 may also be referred to as a "transfer chamber exhauster". The exhauster 290 may further include the vacuum pump 294.

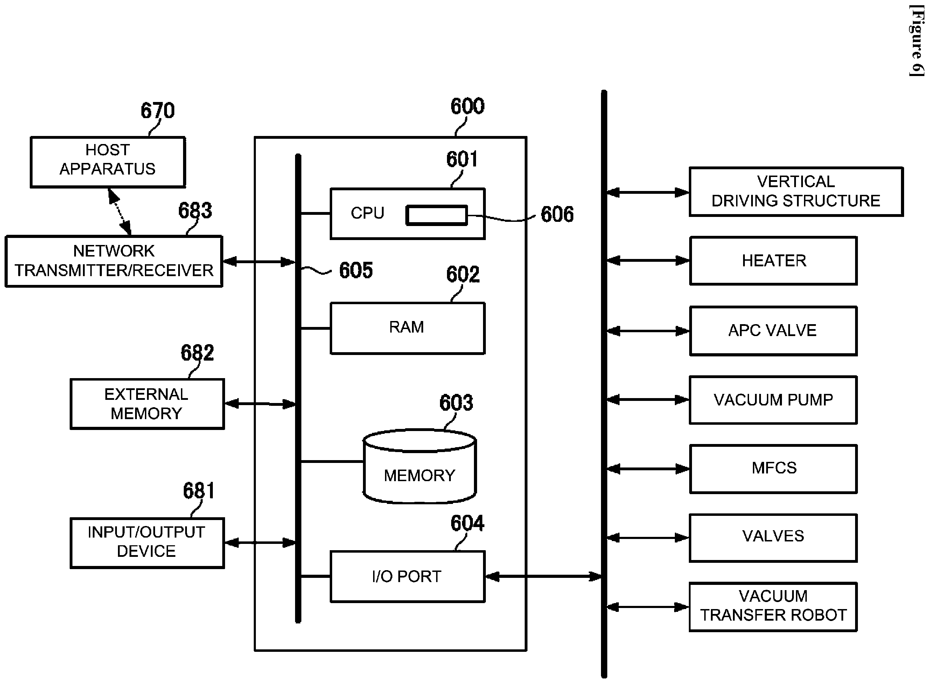

Subsequently, a controller 600 serving as a control structure (control apparatus) will be described with reference to FIG. 6. The substrate processing apparatus 10 includes the controller 600 configured to control operations of components constituting the substrate processing apparatus 10.

FIG. 6 is a diagram schematically illustrating a configuration of the controller 600. The controller 600 may be constituted by a computer including a CPU (Central Processing Unit) 601, a RAM (Random Access Memory) 602, a memory 603 serving as a memory structure and an I/O port (input/output port) 604. The RAM 602, the memory 603 and the I/O port 604 may exchange data with the CPU 601 via an internal bus 605. The transmission/reception of the data in the substrate processing apparatus 10 may be performed by an instruction from a transmission/reception instruction controller 606, which is also one of functions of the CPU 601.

A network transmitter/receiver 683 connected to a host apparatus 670 via a network is provided at the controller 600. For example, the network transmitter/receiver 683 is capable of receiving data such as information regarding a processing history and a processing schedule for the substrate S stored in a pod from the host apparatus 670.

For example, the memory 603 may be embodied by a component such as a flash memory and a HDD (Hard Disk Drive). For example, a control program for controlling the operations of the substrate processing apparatus 10 or a process recipe in which information such as procedures and conditions of the substrate processing is stored may be readably stored in the memory 603.

The process recipe is obtained by combining steps of the substrate processing described later, and acts as a program that is executed by the controller 600 to obtain a predetermined result by performing the steps of the substrate processing described later. Hereinafter, the process recipe and the control program may be collectively or individually referred to simply as a "program". Thus, in the present specification, the term "program" may refer to the process recipe alone, may refer to the control program alone, or may refer to both of the process recipe and the control program. The RAM 602 serves as a memory area (work area) in which the program or the data read by the CPU 601 are temporarily stored.

The I/O port 604 is electrically connected to the components of the substrate processing apparatus 10 described above.

The CPU 601 is configured to read and execute the control program from the memory 603, and is configured to read the process recipe from the memory 603 in accordance with an instruction such as an operation command inputted from an input/output device 681. The CPU 601 is configured to be capable of controlling the substrate processing apparatus 10 in accordance with contents of the process recipe read from the input/output device 681.

The CPU 601 includes the transmission/reception instruction controller 606. For example, the controller 600 according to the present embodiments may be embodied by preparing an external memory 682 (for example, a magnetic disk such as a hard disk, an optical disk such as a DVD, a magneto-optical disk such as an MO, a semiconductor memory such as a USB memory) storing the program described above and by installing the program onto the computer by using the external memory 682. Further, a method of providing the program to the computer is not limited to the external memory 682. For example, the program may be directly provided to the computer by a communication interface such as the Internet and a dedicated line instead of the external memory 682. Further, the memory 603 and the external memory 682 may be embodied by a non-transitory computer-readable recording medium. Hereinafter, the memory 603 and the external memory 682 may be collectively or individually referred to as a "recording medium". In the present specification, the term "recording medium" may refer to the memory 603 alone, may refer to the external memory 682 alone, or may refer to both of the memory 603 and the external memory 682.

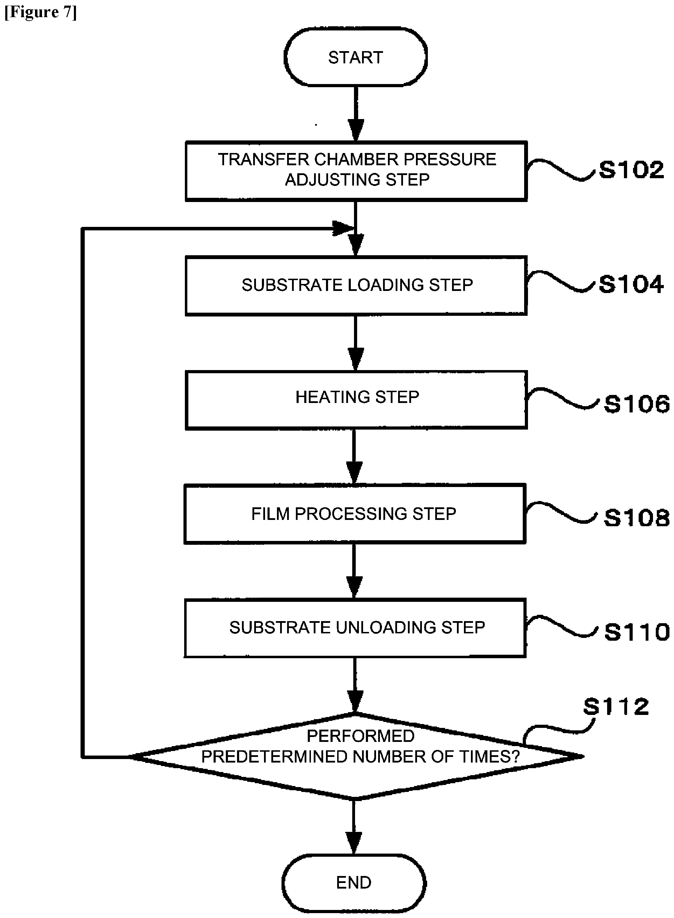

Hereinafter, as a part of a manufacturing process of a semiconductor device, the substrate processing will be described by way of an example in which a film forming process of forming a film on the substrate S is performed by using the substrate processing apparatus 10 described above. The substrate processing will be described with reference to FIGS. 7 to 9 and FIGS. 10(A) to 10(D). Further, in the following description, the controller 600 controls the operations of the components constituting the substrate processing apparatus 10.

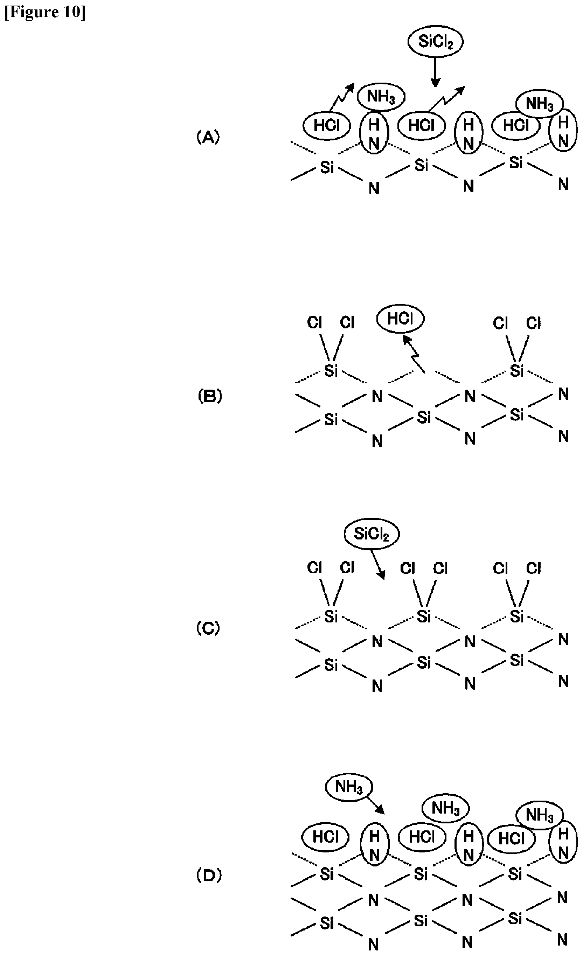

Hereinafter, the film forming process will be described by way of an example in which the film is formed in the concave structure (such as a trench and a hole) of the substrate S using the first gas and the second gas. By supplying the reactive gas such as the NH₃ gas, adsorption sites are formed in advance on a surface of the concave structure of the substrate S. The adsorption sites refer to a region on the surface of the substrate S where molecules or atoms can be adsorbed. In FIG. 10(A), a NH group present on the surface of the substrate S functions as an adsorption site for molecules or atoms.

### <S102>

A transfer chamber pressure adjusting step S102 will be described. In the present step, the inner pressure of the transfer chamber 217 is set to the same level as that of a vacuum transfer chamber (not shown) provided adjacent to the transfer chamber 217. Specifically, by operating the exhauster 290, the inner atmosphere of the transfer chamber 217 is exhausted such that the inner atmosphere of the transfer chamber 217 reaches and is maintained at a vacuum level.

### <S104>

Subsequently, a substrate loading step S104 will be described. When the inner atmosphere of the transfer chamber 217 reaches and is maintained at the vacuum level, a transfer of the substrate S is started. When the substrate S reaches the vacuum transfer chamber, a gate valve is opened. Then, the substrate S is loaded (transferred) into the transfer chamber 217 by the vacuum transfer robot.

In the present step, the substrate support structure 300 stands by in the transfer chamber 217, and the substrate S is transferred to the substrate support structure 300. When a predetermined number of the substrates S are transferred to the substrate support structure 300, the vacuum transfer robot is retracted, and the substrate support structure 300 is elevated by the vertical driving structure 400 to move the substrates S into the reaction tube 210.

When moving the substrate S to the reaction tube 210, the surface of the substrate S is positioned so as to be aligned at the same height as the partition plate 226 and the partition plate 232.

### <S106>

Subsequently, a heating step S106 will be described. When the substrate S is loaded into the reaction tube 210, the inner pressure of the reaction tube 210 is controlled (adjusted) to a predetermined pressure and a surface temperature of the substrate S is controlled to a predetermined temperature. For example, a temperature of the heater 211 is controlled such that a temperature (that is, the surface temperature) of the substrate S reaches and is maintained at a temperature within a range from 100 °C to 1,500 °C, preferably from 200 °C to 1,000 °C, and more preferably from 400 °C to 800 °C. Further, for example, it is conceivable that the inner pressure of the reaction tube 210 reaches and is maintained at a pressure within a range from 5 Pa to 100 kPa.

### <S108>

Subsequently, a film processing step S108 will be described. The film processing step S108 is performed after the heating step S106. In the film processing step S108, in accordance with the process recipe, as described below, with respect to the concave structure of the substrate S where the adsorption site is provided on the surface of the substrate S, a first gas supply step of supplying the first gas to the substrate S and a second gas supply step of supplying the second gas to the substrate S are repeatedly performed a predetermined number of times so as to form a predetermined film on the substrate S where the concave structure is provided on the surface of the substrate S.

When the gas is supplied, the flow of the gas is formed at the upstream side gas guide 214, a space on the substrate S and the downstream side gas guide 215. Since the gas is supplied to each of the substrates S without the pressure loss on each of the substrates S, it is possible to perform a processing uniform between the substrates S.

Further, each of the upstream side gas guide 214 and the downstream side gas guide 215 may be configured to correspond to the substrates S. In such a case, it is advantageous in that the number of components can be reduced. However, a pressure between the substrates S or the gas hitting a side surface of the substrate S may cause a turbulent flow, so that a gas supply situation changes between the substrates arranged above and below among the substrates S. As a result, variations in the processing may occur between the substrates S. In particular, when the turbulent flow occurs, there is a risk that the gas will stagnate before reaching the substrate S. Then, the gas will be decomposed before reaching the substrate S. As a result, the gas may be deposited on an edge of the substrate S. Thereby, a uniformity of the processing within the surface of the substrate S may be lowered.

As a result, variations may occur in the film processing step S108. Therefore, providing the upstream side gas guide 214 and the downstream side gas guide 215 corresponding to one substrate S as in the present embodiments is advantageous in reducing the variations in the processing between the substrates S.

### <First Gas Supply Step>

First, the first gas supply step of supplying the first gas to the concave structure of the substrate S (where the adsorption site is provided on the surface of the substrate S) will be described. In the first gas supply step, a first gas flash supply (step A), a purge (step B), a first gas continuous supply (step C) and a purge (step D) are performed in combination as described below.

In the present specification, the term "flash supply" refers to a method (manner) of supplying a large amount of a gas at once into the reaction tube 210. Specifically, in the flash supply, the gas is stored in a tank provided in a gas supply pipe in advance, and when supplying the gas, a valve provided downstream of the tank between the tank and a nozzle is opened, thereby supplying the gas at a faster speed as compared with a "continuous supply" described later.

### <First Gas Flash Supply (Step A)>

In the present step, the valve 254 is opened so as to supply the first gas into the gas supply pipe 251 from the tank 259 in which the first gas is stored in advance. After a predetermined time (for example, within a range from 0.1 second to 5 seconds, for example, 0.3 second) has elapsed, the valve 254 is closed to stop a supply of the first gas into the gas supply pipe 251. The first gas is supplied in a large amount at once into the reaction tube 210 from the gas supply structure 212 via the upstream side gas guide 214. Then, the first gas is exhausted through the space on the substrate S, the downstream side gas guide 215, the gas exhaust structure 213 and the exhaust pipe 281. In the present step, while the first gas is being supplied into the process chamber 201, the valve 275 may be opened or closed. Further, when the first gas is being supplied, the valve 258 may be opened so as to supply the inert gas such as the N₂ gas into the gas supply pipe 251 via the gas supply pipe 255. Further, when the first gas is being supplied, in order to prevent the first gas from entering the gas supply pipe 261, the valves 268 and 264 may be opened so as to supply the inert gas into the gas supply pipe 261.

In the present step, for example, the APC valve 283 is appropriately adjusted such that the inner pressure of the reaction tube 210 is set to be a pressure within a range from 1 Pa to 3,990 Pa. In the following, for example, the temperature of the heater 211 is adjusted such that the temperature of the substrate S reaches and is maintained at a temperature within a range from 100 °C to 1,500 °C, preferably from 400 °C to 800 °C.

In the present step, the first gas is supplied in a large amount at once from beside the substrate S to the substrate S in the horizontal direction through the gas supply structure 212 (which is in communication with the inner portion of the reaction tube 210). In the present step, for example, a flow velocity of the first gas is set to be a flow velocity within a range from 0.5 m/second to 100 m/second, preferably from 1 m/second to 50 m/second, and more preferably from 2 m/second to 50 m/second.

As the first gas, a gas in which at least two silicon atoms are bonded (for example, the Si₂Cl₆ gas (hereinafter, also referred to as the "HCDS gas") containing silicon and chlorine) may be used.

For example, when the HCDS gas is used as the first gas, since the Si - Si bond contains a binding energy as high as to be broken by the collision with the wall, the Si - Si bond is broken by an impact of the collision with the wall 700 constituting the concave structure, and is decomposed into SiCl₂ and SiCl₄ which serve as a precursor. Then, the SiCl₂ whose adsorption degree (that is, degree of adsorption) is high is adsorbed to an upper portion of the concave structure, and the SiCl₄ whose adsorption degree is lower than that of the SiCl₂ moves to a lower portion of the concave structure. Therefore, by reacting the SiCl₂ with the NH group at the upper portion of the concave structure and by reacting the SiCl₄ with the NH group at the lower portion of the concave structure, a silicon nitride layer (SiN layer) is formed. In addition, when the SiN layer is being formed, a reaction by-product such as hydrogen chloride (HCl) may also be generated. In the present embodiments, the term "adsorption degree" may refer to a degree of ease of adsorption.

The HCl serving as the reaction by-product may adsorb to NH groups and may inhibit the bonding between silicon and the NH groups. Further, when the SiCl₂ and the SiCl₄ adsorb to the NH groups, an amount of the HCl generated when the SiCl₄ adsorbs to the NH group is greater than an amount of the HCl generated when the SiCl₂ adsorbs to the NH group. In addition, due to a structure in which the gas is supplied by a side flow as described above, the gas is easily depleted at the lower portion of the concave structure. In other words, the SiCl₂ is more likely to contribute to a film formation at the upper portion of the concave structure, and the SiCl₄ is more likely to contribute to the film formation at the lower portion of the concave structure. As a result, a thickness of the film may differ between the upper and lower portions of the concave structure. Thereby, a thickness uniformity of the film within the concave structure may deteriorate, and a step coverage may also deteriorate.

In addition, although the HCl generated in the upper portion of the concave structure is discharged to the outside of the concave structure, the HCl remains in the lower portion of the concave structure. Thereby, voids may be formed in the concave structure. As a result, the step coverage may further deteriorate.

Therefore, in the step A, the first gas is supplied at a rate (or a speed) faster than an adsorption rate (or an adsorption speed) at which the precursor of the first gas is adsorbed to the adsorption site (for example, the NH group) on the surface of the substrate S. As a result, the first gas collides with the wall 700 constituting the concave structure of the substrate S, and is decomposed into a first component and a second component whose adsorption degree is lower than that of the first component. Thereby, a predetermined amount of the first component is generated in the concave structure. Therefore, a precursor of the first component which is decomposed in a manner described above adheres to an inner surface of the wall 700 constituting the concave structure. In other words, in the present step, the first component of the first gas can be exposed in a large amount and adsorbed to the adsorption site of the concave structure of the substrate S in a short time.

In the present embodiments, the adsorption rate may refer to a rate (speed) at which the precursor of the first gas can be adsorbed to the adsorption site of the substrate S, and may refer to a rate (speed) at which the precursor of the first component of the first gas (which will be described later) is adsorbed to the adsorption site. In addition, the rate faster than the adsorption rate at which the precursor of the first gas is adsorbed to the adsorption site on the surface of the substrate S may refer to a rate at which the precursor of the first gas is supplied to the lower portion of the concave structure of the substrate S and adsorbed before the precursor of the first gas is adsorbed to the adsorption site in the upper portion of the concave structure.

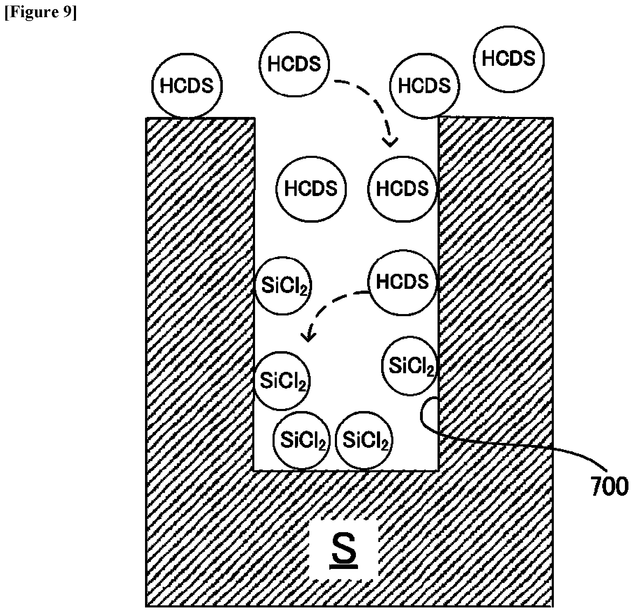

For example, when the HCDS gas is used as the first gas, the HCDS gas in an undecomposed sate is supplied into the process chamber 201 from the side portion of the substrate S. In such a case, a supply rate (or a supply speed) of the first gas is set to a rate faster than the adsorption rate at which the precursor of the first gas is adsorbed to the adsorption site on a side surface of the concave structure. In the present embodiments, as shown in FIG. 9, the first gas is collided with the wall 700 constituting the concave structure, and the Si - Si bond of the HCDS (Si₂Cl₆) gas is broken by the collision. After the Si - Si bond is broken, the HCDS gas is decomposed into the SiCl₂ serving as the precursor of the first component, and the SiCl₄ serving as the precursor of the second component. Since the SiCl₂ and the SiCl₄ are substances formed in the middle of the film formation, the SiCl₂ and the SiCl₄ may also be referred to as "intermediates". The adsorption degree of the SiCl₂ (which is decomposed) is higher than that of the SiCl₄ (which is decomposed). Therefore, a probability that the SiCl₂ is adsorbed to the NH group serving as the adsorption site is higher than a probability that the SiCl₄ is adsorbed to the NH group serving as the adsorption site. In other words, a coverage rate of the SiCl₂ is higher than the SiCl₄. Therefore, as shown in FIG. 10(A), in the present step, the SiCl₂ whose adsorption degree is higher than that of the SiCl₄ is adsorbed to the NH group in the concave structure, and the HCl is desorbed or remains.

For example, since most of the SiCl₂ will be combined with and be consumed at the upper portion of the concave structure, there is a concern that a relatively small amount of the SiCl₂ will be supplied to the lower portion of the concave structure. However, according to the present embodiments, since the first gas is supplied at the rate faster than the adsorption rate of the first component, it is possible to supply SiCl₂ to the lower portion of the concave structure before a large amount of the SiCl₂ is consumed at the upper portion of the concave structure. Therefore, it is possible to form a silicon-containing layer whose step coverage performance is improved.

### <Purge (Step B)>

In the present step, the purge gas is supplied to the concave structure of the substrate S (where the adsorption site is provided on the surface of the substrate S). In other words, after the first gas flash supply (that is, the step A), a substance such as the first and second components (which are not adsorbed to the adsorption sites) and the reaction by-product such as the HCl (which is generated by the surface reaction and re-adsorbed on the surface of the substrate S) may be desorbed and removed from the reaction tube 210.

Specifically, with the valve 254 open, the valve 275 is closed and the valves 258, 268 and 264 are opened to supply the inert gas serving as the purge gas into the gas supply pipes 251 and 261 via the gas supply pipes 255 and 265. In addition, with the valve 282 and APC valve 283 of the exhaust pipe 281 open, the reaction tube 210 is vacuum-exhausted by the vacuum pump 284. Thereby, it is possible to suppress the reaction between the first gas and the second gas in a gaseous state existing in the reaction tube 210. For example, as shown in FIG. 10(B), the HCl (which serves as the reaction by-product adsorbed to the lower portion of the concave structure of the substrate S) is desorbed and discharged from the reaction tube 210.

In particular, although it is possible to supply a large amount of the SiCl₂ to the lower portion of the concave structure as described above, a large amount of the SiCl₄ is also supplied to the lower portion of the concave structure. This is because the adsorption degree of the SiCl₂ is higher than that of the SiCl₄, and at the upper portion of the concave structure, the SiCl₂ is bonded more than the SiCl₄. Therefore, the HCl is generated more at the lower portion of the concave structure than at the upper portion of the concave structure. The HCl generated as described above is supplied between the adsorption site and the SiCl₄ or between the adsorption site and the SiCl₂, and thereby, may inhibit the adsorption. Therefore, in order to further improve the step coverage performance, it is preferable to exclude (or remove) the HCl.

Therefore, in the present step, the purge gas is supplied to the concave structure so as to desorb the HCl generated in the concave structure (in particular, in the lower portion of the concave structure) such that the adsorption site remains vacant (unbonded) and the component of the first gas supplied in a subsequent step (that is, the step C) can be adsorbed to the adsorption site. Further, the HCl desorbed in a manner described above is discharged from the concave structure and exhausted through the exhaust pipe 281.

### <First Gas Continuous Supply (Step C)>

In the present step, the gas is supplied at a rate slower than the supply rate of the first gas in the step A. For example, the first gas is supplied to the concave structure of the substrate S at a rate slower than the adsorption rate of the precursor.

Specifically, with the valve 254 open, the valve 275 is opened so as to supply the first gas into the gas supply pipe 251. The first gas whose flow rate is adjusted by the MFC 253 is supplied into the reaction tube 210 from the gas supply structure 212 via the upstream side gas guide 214. Then, the first gas is exhausted through the space on the substrate S, the downstream side gas guide 215, the gas exhaust structure 213 and the exhaust pipe 281. When the first gas is being supplied, the valve 258 may be opened so as to supply the inert gas such as the N₂ gas into the gas supply pipe 251 via the gas supply pipe 255. Further, when the first gas is being supplied, in order to prevent the first gas from entering the gas supply pipe 261, the valves 268 and 264 may be opened so as to supply the inert gas into the gas supply pipe 261.

In the present step, for example, a supply flow rate of the first gas controlled (or adjusted) by the MFC 253 is set to be a flow rate within a range from 0.1 slm to 20 slm. For example, a supply time (time duration) of supplying the first gas onto the substrate S is set to be a time within a range from 0.1 second to 1,000 seconds. For example, a flow velocity of the first gas is set to be a flow velocity within a range from 0.1 m/second to 100 m/second, preferably from 0.5 m/second to 50 m/second, and more preferably from 1 m/second to 20 m/second.

In the present step, the gas is supplied to the side surface of the concave structure of the substrate S (where the adsorption site is provided on the surface of the substrate S) at the rate slower than the supply rate in the step A. In the present step, since a lot of the adsorption sites are filled, even when the rate is slow, it is possible to bond the gas to the adsorption site. By supplying the gas at a slow rate, it is possible to suppress a consumption amount of the first gas.

Further, when a sufficient amount of the SiCl₂ is supplied to the lower portion of the concave structure in the step A, it is sufficient to supply the SiCl₂ to vacant adsorption sites mainly present in the upper portion of the concave structure. Therefore, the gas may be supplied at a slower rate than in the step A, for example, at a rate slower than a bonding rate of the SiCl₂. Thereby, it is possible to suppress the consumption amount of the first gas.

Further, when it is determined that there are a lot of vacant adsorption sites in the lower portion of the concave structure after the step A, the first gas may be supplied at a rate slower than the supply rate of the firs gas in the step A but faster than the bonding rate of the SiCl₂. Even in such a case, as in the step A, a large amount of the SiCl₂ can be supplied to the lower portion of the concave structure. Thereby, it is possible to improve the step coverage performance even when there are a lot of vacant adsorption sites in the lower portion of the concave structure.

As a result, for example, as shown in FIG. 10(C), the SiCl₂ after the decomposition of the HCDS gas can be adsorbed to the adsorption site formed by desorbing the reaction by-product such as the HCl shown in FIG. 10(B) or to the adsorption site that is unbonded even in the step A. In such a state, since the number of adsorption sites is reduced as compared with that before the step A, it is sufficient to supply the first gas in an amount corresponding to an amount of the adsorption sites, and therefore the first gas may be supplied in an amount smaller than that in the step A.

### <Purge (Step D)>

In the present step, the purge gas is supplied to the concave structure of the substrate S (where the adsorption site is provided on the surface of the substrate S) after the step C. In other words, the first gas is supplied again to the adsorption site formed by removing the reaction by-product. That is, a purge is performed. Further, since the present step is similar to the step B described above, the present step may be replaced with the step B.

After a predetermined time has elapsed since the first gas continuous supply is started, with the valve 254 open, the valve 275 is closed to stop the supply of the first gas. In addition, the valves 258, 268 and 264 are opened to supply the inert gas serving as the purge gas into the gas supply pipes 251 and 261 via the gas supply pipes 255 and 265. In addition, with the valve 282 and APC valve 283 of the exhaust pipe 281 open, the reaction tube 210 is vacuum-exhausted by the vacuum pump 284. Thereby, it is possible to suppress the reaction in a gaseous substance existing in the reaction tube 210. That is, the HCl (which serves as the reaction by-product adsorbed to the lower portion of the concave structure of the substrate S) and a residual gas are discharged from the reaction tube 210.

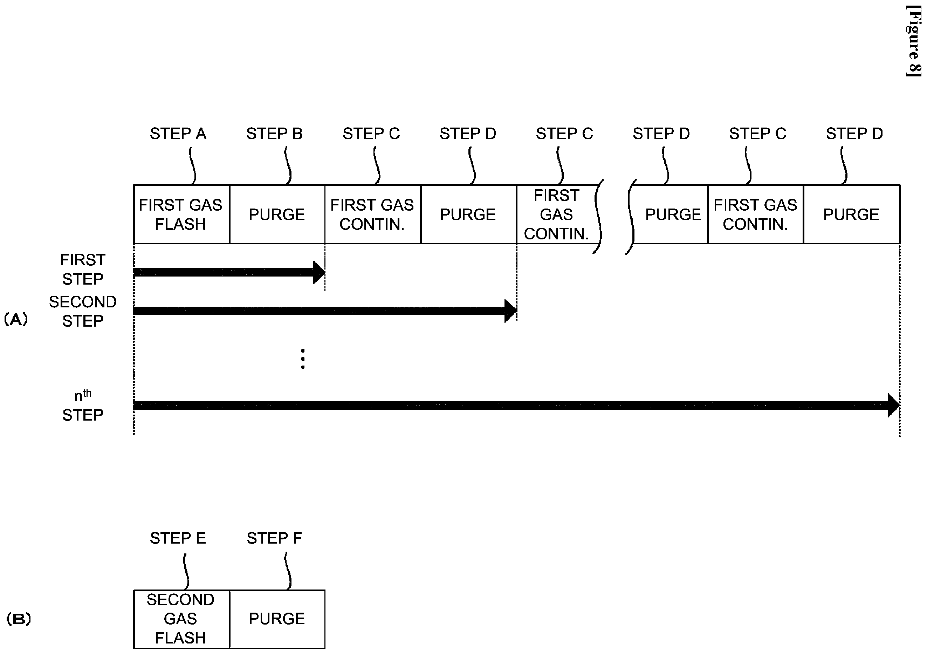

The first gas is supplied to the concave structure of the substrate S (where the adsorption site is provided on the surface of the substrate S) by combing the step A, the step B, the step C and the step D described above as shown in FIG. 8(A).

Specifically, as the first gas supply step, a first step in which the first gas flash supply (that is, the step A) and a purge gas supply (that is, the step B) are performed sequentially in this order; a second step in which the first gas flash supply (that is, the step A), the purge gas supply (that is, the step B), the first gas continuous supply (that is, the step C) and a purge gas supply (that is, the step D) are performed sequentially in this order; and an n^{th} step in which the first gas flash supply (that is, the step A) and the purge gas supply (that is, the step B) are performed and then the first gas continuous supply (that is, the step C) and the purge gas supply (that is, the step D) are repeatedly performed a predetermined number of times (n times, n is an integer of 1 or more) can be performed.

In the present specification, such a film forming sequence of the present embodiments described above may be illustrated as follows for convenience. Film forming sequences of modified examples and other embodiments (which will be described later) will be also represented in the same manner.
First step: Step A → Step B;
Second step: Step A → Step B → Step C → Step D; and
n^{th} step: Step A → Step B → (Step C → Step D) × (n-1)

That is, as the first gas supply step, the first step, the second step and the n^{th} step described above are performed. As described above, by increasing the number of steps and thereby increasing the number of times of performing the step C and the step D, it is possible to adsorb the precursor of the first gas (whose coverage rate is good and whose generation amount of the reaction by-product is small) to the vacant adsorption sites in the concave structure.

By performing the first step to the n^{th} step described above, a film containing the first gas (that is, a film containing the source gas) is formed in the concave structure of the substrate S. That is, by performing the first step to the n^{th} step and thereby repeatedly performing the steps, it is possible to improve the step coverage.

In the present embodiments, while the step C and the step D are repeatedly performed (executed) in the n^{th} step described above, a time duration (process time) of performing the step D when the number of executions of the step D is smaller is set to be longer than a time duration of performing the step D when the number of executions of the step D is greater. In other words, in repeatedly performing the step C and the step D, , the time duration of performing the step D decreases as the number of executions of the step D increases. This is because the number of the adsorption sites on the surface of the substrate S decreases as the number of executions increases. Thereby, by supplying an appropriate amount of the gas, it is possible to eliminate a waste of the gas and it is also possible to improve a throughput.

Further, while the step C and the step D are repeatedly performed in the n^{th} step described above, an amount of the inert gas supplied per unit time in the step D when the number of executions of the step D is smaller may be set to be greater than an amount of the inert gas supplied per unit time in the step D when the number of executions of the step D is greater. In other words, in repeatedly performing the step C and the step D, , the amount of the inert gas supplied per unit time in the step D may be set to decrease as the number of executions increases.

Further, while the step C and the step D are repeatedly performed in the n^{th} step described above, a time duration of performing the step C when the number of executions of the step C is smaller is set to be longer than a time duration of performing the step C when the number of executions of the step C is greater. In other words, in repeatedly performing the step C and the step D, , the time duration of performing the step C is set to decrease as the number of executions of the step C increases. This is because, similar to the time of performing the step D described above, the number of the adsorption sites on the surface of the substrate S decreases as the number of executions increases. Thereby, by supplying an appropriate amount of the gas, it is possible to eliminate the waste of the gas and it is also possible to improve the throughput.

Further, while the step C and the step D are repeatedly performed in the n^{th} step described above, an amount of the first gas supplied per unit time in the step C when the number of executions of the step C is smaller may be set to be greater than an amount of the first gas supplied per unit time in the step C when the number of executions of the step C is greater. In other words, in repeatedly performing the step C and the step D, the amount of the first gas supplied per unit time in the step C may be set to decrease as the number of executions increases.

Further, a time duration of performing the purge step (that is, the step B) performed immediately after the step A described above is set to be longer than a time duration of performing the purge step (that is, the step D) performed immediately after the step C described above. This is because the number of the adsorption sites on the surface of the substrate S that remain immediately after the step C is smaller than the number of the adsorption sites that remain immediately after the step A, so that the generation of the reaction by-product is suppressed. Thereby, by supplying an appropriate amount of the gas while suppressing the generation of the reaction by-product, it is possible to eliminate the waste of the gas and it is also possible to improve the throughput.

Further, an amount of the inert gas supplied per unit time in the purge step (that is, the step B) performed immediately after the step A described above may be set to be greater than an amount of the inert gas supplied per unit time in the purge step (that is, the step D) performed immediately after the step C described above.

### <Second Gas Supply Step>

Subsequently, the second gas supply step of supplying the second gas to the concave structure of the substrate S will be described. In the second gas supply step, as shown in FIG. 8(B), a second gas flash supply (step E) and a purge (step F) are performed as described below.

### <Second Gas Flash Supply (Step E)>

In the present step, the valve 264 is opened so as to supply the second gas into the gas supply pipe 261 from the tank 269 in which the second gas is stored in advance. After a predetermined time (for example, within a range from 0.1 second to 1,000 seconds, for example, 0.3 second ) has elapsed, the valve 264 is closed to stop a supply of the second gas into the gas supply pipe 261. The second gas is supplied into the reaction tube 210 from the gas supply structure 212 via the upstream side gas guide 214. Then, the second gas is exhausted through the space on the substrate S, the downstream side gas guide 215, the gas exhaust structure 213 and the exhaust pipe 281. In the present step, while the second gas is being supplied into the process chamber 201, the valve 276 may be opened or closed. Further, when the second gas is being supplied, the valve 268 may be opened so as to supply the inert gas such as the N₂ gas into the gas supply pipe 261 via the gas supply pipe 265. Further, when the second gas is being supplied, in order to prevent the second gas from entering the gas supply pipe 251, the valves 258 and 254 may be opened so as to supply the inert gas into the gas supply pipe 251.

In the present step, the second gas is supplied in a large amount at once from beside the substrate S to the substrate S in the horizontal direction through the gas supply structure 212 (which is in communication with the inner portion of the reaction tube 210). In the present step, for example, a flow velocity of the second gas is set to be a flow velocity within a range from 0.1 m/second to 20 m/second, preferably from 0.1 m/second to 10 m/second, and more preferably from 0.1 m/second to 5 m/second.

As the second gas, a gas different from the first gas and reacting with the precursor of the first gas, for example, the NH₃ gas serving as a nitrogen-containing gas may be used. As described above, the second gas is supplied to the surface of the substrate S from beside the substrate S. Then, the second gas is supplied into the concave structure to form an adsorption site, and reacts with the precursor adhered to the wall 700 constituting the concave structure. Thereby, a desired film is formed on the substrate S including an inside of the concave structure. Specifically, as shown in FIG. 10(D), the NH₃ gas supplied into the concave structure is adsorbed on the surface of the substrate S and reacts with the SiCl₂ adsorbed in the concave structure to form the NH group, and thereby, a reaction by-product such as ammonium chloride (NH₄Cl) and the HCl is generated.

In the present step, in a case where the NH₃ gas is used as the second gas, when the HCDS gas and the NH₃ gas react with each other, NH₂ bonds are generated on the film. When the HCDS supplied thereafter reacts with the NH₂, chlorine (Cl) or hydrogen chloride (HCl) may be generated. When chlorine or the HCl remains between the SiCl₂ and the inner wall of the concave structure, chlorine or the HCl may inhibit the SiCl₂ from adhering to the inner wall of the concave structure. Therefore, a temperature of the present step is set to a temperature at which the by-product such as the NH₂ generated in the concave structure of the substrate S can be desorbed and at which the decomposition of the HCDS gas serving as the first gas is not promoted. In addition, the NH₃ gas is supplied from beside the substrate S for a time duration in which the HCDS is not decomposed and the SiCl₂ is not generated.

### <Purge (Step F)>

In the present step, the purge gas is supplied to the concave structure of the substrate S (where the adsorption site is provided on the surface of the substrate S) after the step E. In other words, after the second gas flash supply, a substance such as the second gas (which is not adsorbed to the adsorption site) and the reaction by-product such as the HCl and the NH₄Cl (which is generated by reacting with the second gas and re-adsorbed on the surface of the substrate S) may be desorbed and removed from the reaction tube 210.

Specifically, with the valve 264 open, the valve 276 is closed and the valves 268, 258 and 254 are opened to supply the inert gas serving as the purge gas into the gas supply pipes 251 and 261 via the gas supply pipes 255 and 265. In addition, with the valve 282 and APC valve 283 of the exhaust pipe 281 open, the reaction tube 210 is vacuum-exhausted by the vacuum pump 284. Thereby, it is possible to suppress the reaction between the first gas and the second gas in the gaseous state existing in the reaction tube 210.

### <Performing Predetermined Number of Times>

By performing a cycle (in which the first gas supply step and the second gas supply step described above are sequentially and non-simultaneously performed in this order) a predetermined number of times (N times, where N is an integer of 1 or more) (that is, one or more times), a film of a predetermined thickness is formed on the substrate S where the concave structure is provided. According to the present embodiments, for example, a silicon nitride film (SiN film) is formed. That is, after performing the first gas supply step and the second gas supply step, the above-mentioned cycle that starts from the step A is performed the predetermined number of times. As a result, a film whose step coverage performance is improved can be formed on the substrate S provided with the concave structure.

### <S110>

Subsequently, a substrate unloading step S110 will be described. In the substrate unloading step S110, the substrate S processed as described above is transferred (unloaded) out of the transfer chamber 217 in the order reverse to that of the substrate loading step S104.

### <S112>

Subsequently, a determination step S112 will be described. In the present step, it is determined whether or not the processing of the substrate S described above (that is, the step S104 through S110) has been performed a predetermined number of times. When it is determined that the processing has not been performed the predetermined number of times, the substrate loading step S104 is performed again to process a subsequent substrate S to be processed. When it is determined that the processing has been performed the predetermined number of times, the substrate processing is terminated.

While the present embodiments are described by way of an example in which the horizontal gas flow is formed, it is sufficient as long as a main flow of the gas is generally formed in the horizontal direction. Further, a gas flow may be diffused in the vertical direction as long as it does not affect a uniform processing of the plurality of substrates.

Further, in the above, various expressions such as "the same", "equal", "similar" and the like are used. However, it goes without saying that the expressions described above mean "substantially the same".

### (4) Modified Examples

### <First Modified Example>

For example, the embodiments mentioned above are described by way of an example in which the substrate S where the adsorption site is provided in advance on the surface of the substrate S is used. According to the present modified example, the substrate S whose surface is not provided with the adsorption site thereon in advance is used. That is, according to the present modified example, the second gas supply step described above is performed before the first gas supply step in the substrate processing described above. That is, before performing the step A described above, a step of forming the adsorption site such as the NH group in the concave structure of the substrate S is performed.

Specifically, the substrate S whose surface is not provided with the adsorption site thereon in advance is transferred (or loaded) into the reaction tube 210, and the step E and the step F are performed to form the adsorption site (for example, the NH group) on the surface of the concave structure of the substrate S. Thereafter, the first gas supply step and the second gas supply step are performed a predetermined number of times. Even in such a case, it is possible to obtain substantially the same effect as in the embodiments mentioned above.

### <Second Modified Example>

According to the present modified example, the second gas supplier 260 described above does not include the tank 269. In other words, the second gas may be supplied continuously rather than by the flash supply. Even in such a case, it is possible to obtain substantially the same effect as in the embodiments mentioned above.

### <Third Modified Example>

According to the present modified example, after performing the steps A to F described above in this order, the step C described above is performed. Even in such a case, it is possible to obtain substantially the same effect as in the embodiments mentioned above.

### <Other Embodiments of Present Disclosure>

While the technique of the present disclosure is described in detail by way of the embodiments mentioned above, the technique of the present disclosure is not limited thereto and may be modified in various ways without departing from the scope thereof.

For example, the embodiments mentioned above are described by way of an example in which, in the film forming process performed by the substrate processing apparatus 10, the film is formed on the substrate S by using the first gas and the second gas. However, the technique of the present disclosure is not limited thereto. That is, as the process gases used in the film forming process, other gases may be used to form different films. Further, the technique of the present disclosure may also be applied to film forming processes using three or more different process gases as long as the three or more different process gases are non-simultaneously supplied (that is, supplied in a non-overlapping manner).

For example, the embodiments mentioned above are described by way of an example in which the film forming process is performed by the substrate processing apparatus. However, the technique of the present disclosure is not limited thereto. That is, the technique of the present disclosure can be applied not only to the film forming process of forming the film exemplified in the embodiments mentioned above but also to other film forming processes of forming other films. For example, the embodiments mentioned above are described by way of an example in which the substrate processing apparatus capable of stacking and processing the plurality of substrates is used. However, the technique of the present disclosure is not limited thereto. For example, the technique of the present disclosure can also be applied to a single wafer type substrate processing apparatus capable of processing a single substrate at a time. Further, one or more constituents of the above-described embodiments may be substituted with one or more constituents of other embodiments, or may be added to other embodiments. Further, a part of one or more constituents of the above-described embodiments may be omitted, or substituted with or added to other constituents.

The technique of the present disclosure is described in detail by way of the embodiments mentioned above. However, the technique of the present disclosure is not limited thereto. For example, the technique of the present disclosure may also applied when the embodiments mentioned above are appropriately combined.

Hereinafter, examples of the embodiments of the present disclosure will be described.

### <First Example>

According to the present example, the substrate processing mentioned above is performed using the substrate processing apparatus 10 shown in FIG. 1. FIG. 11(A) is a diagram schematically illustrating a relationship between the number of the steps of the first gas supply and the step coverage according to the present example. FIG. 11(B) is a diagram schematically illustrating a relationship between the number of the steps of the first gas supply and a thickness of a layer formed on the upper portion or the lower portion of the concave structure of the substrate according to the present example. FIG. 11(C) is a diagram schematically illustrating the upper portion and the lower portion of the concave structure of the substrate according to the present example.

As shown in FIGS. 11 (A) and 11(B), it is confirmed that, by using the present example, a difference in a thickness between the layer formed on the upper portion of the concave structure of the substrate and the layer formed on the lower portion of the concave structure of the substrate can be reduced. In other words, it is confirmed that, by using the substrate processing mentioned above, it is possible to improve the step coverage depending on the number of the steps of the first gas supply.

**[Description of Reference Numerals]**

| | | | |
|---|---|---|---|
| S | substrate | 10 | substrate processing apparatus |
| 201: | process chamber | 210 | reaction tube |
| 600 | controller | | |

## Claims

1. A method of manufacturing a semiconductor device, comprising:
(a) supplying a source gas to a concave structure of a substrate provided with an adsorption site on a surface thereof at a rate faster than an adsorption rate at which a precursor of the source gas is adsorbed to the adsorption site;
(b) supplying a purge gas to the concave structure; and
(c) supplying the source gas to the concave structure at a rate slower than the adsorption rate.

2. The method of claim 1, wherein the source gas is decomposed into a first component to be adsorbed to the adsorption site and a second component whose adsorption degree is lower than that of the first component, and
the adsorption rate is set to a rate at which a precursor of the first component is adsorbed to the adsorption site.

3. The method of claim 1, further comprising:
(d) supplying the purge gas to the concave structure after (c); and
(e) supplying a reactive gas reacting with the precursor of the source gas to the concave structure.

4. The method of claim 3, further comprising
(f) supplying the purge gas to the concave structure after (e),
wherein (a) is performed after (f).

5. The method of claim 3, further comprising
(f) supplying the purge gas to the concave structure after (e),
wherein (c) is performed after (f).

6. The method of claim 1, wherein (b) and (c) are repeatedly performed after (c) is performed.

7. The method of claim 6, wherein, in repeatedly performing (b) and (c), a time duration of performing (b) when the number of executions of (b) is smaller is set to be longer than a time duration of performing (b) when the number of executions of (b) is greater.

8. The method of claim 6, wherein, in repeatedly performing (b) and (c), a time duration of performing (b) is set to decrease as the number of executions of (b) increases.

9. The method of any one of claims 6 through 8, wherein, in repeatedly performing (b) and (c), a time duration of performing (b) immediately after (a) is set to be longer than a time duration of performing (b) immediately after (c).

10. The method of any one of claims 6 through 9, wherein, in repeatedly performing (b) and (c), a time duration of performing (c) when the number of executions of (c) is smaller is set to be longer than a time duration of performing (c) when the number of executions of (c) is greater

11. The method of any one of claims 6 through 9, wherein, in repeatedly performing (b) and (c), a time duration of performing (c) is set to decrease as the number of executions of (c) increases.

12. The method of claim 1, further comprising
forming the adsorption site in the concave structure before (a).

13. The method of claim 1 or 12, further comprising
forming the adsorption site in the concave structure after (a).

14. The method of any one of claims 1 through 6, wherein the source gas comprises a gas at least containing a silicon - silicon bond.

15. The substrate processing method of claim 14, wherein the source gas comprises Si₂Cl₆ gas.

16. The method of any one of claims 3 through 5, wherein the reactive gas comprises a gas containing hydrogen and nitrogen, and the adsorption site comprises a NH group.

17. The substrate processing method of claim 2, wherein, in (a), by supplying the source gas in an undecomposed state from a side portion of the substrate to cause the source gas to collide with the concave structure, the source gas is decomposed into the first component and the second component, and a predetermined amount of the first component is generated in the concave structure, and
wherein, in (c), by supplying the source gas in an undecomposed state from the side portion of the substrate to cause the source gas to collide with the concave structure, the source gas is decomposed into the first component and the second component, and the first component is generated in an amount smaller than the predetermined amount in the concave structure.

18. A method of manufacturing a semiconductor device, comprising:
supplying a source gas to a concave structure of a substrate provided with an adsorption site on a surface thereof at a rate faster than an adsorption rate at which a precursor of the source gas is adsorbed to the adsorption site.

19. A substrate processing method comprising:
(a) supplying a source gas to a concave structure of a substrate provided with an adsorption site on a surface thereof at a rate faster than an adsorption rate at which a precursor of the source gas is adsorbed to the adsorption site;
(b) supplying a purge gas to the concave structure; and
(c) supplying the source gas to the concave structure at a rate slower than the adsorption rate.

20. A substrate processing apparatus comprising:
a process chamber in which a substrate is processed;
a gas supplier configured to be capable of supplying a source gas into the process chamber; and
a controller configured to be capable of controlling the gas supplier to perform:
(a) supplying the source gas to a concave structure of the substrate provided with an adsorption site on a surface thereof in the process chamber at a rate faster than an adsorption rate at which a precursor of the source gas is adsorbed to the adsorption site;
(b) supplying a purge gas to the concave structure; and
(c) supplying the source gas to the concave structure at a rate slower than the adsorption rate.

21. A program that causes a substrate processing apparatus, by a computer, to perform:
(a) supplying a source gas to a concave structure of a substrate provided with an adsorption site on a surface thereof in a process chamber of the substrate processing apparatus at a rate faster than an adsorption rate at which a precursor of the source gas is adsorbed to the adsorption site;
(b) supplying a purge gas to the concave structure; and
(c) supplying the source gas to the concave structure at a rate slower than the adsorption rate.
